Europäisches Patentamt

European Patent Office

Office européen des brevets

(11) Publication number: **0 057 593**
A2

# EUROPEAN PATENT APPLICATION

(21) Application number: **82300478.3**

(51) Int. Cl.³: **G 03 F 7/02, B 41 N 1/12**

(22) Date of filing: **29.01.82**

(30) Priority: **02.02.81 US 230926**

(43) Date of publication of application: **11.08.82 Bulletin 82/32**

(84) Designated Contracting States: **DE FR GB IT NL**

(71) Applicant: **UNIROYAL, INC., 1230 Avenue of the Americas Rockefeller Center, New York, New York 10020 (US)**

(72) Inventor: **Worns, John R., 1436 Tremont Drive, Mishawaka Indiana (US)**
Inventor: **Chase, James W., Box 59779 Rte.1 Clover, Mishawaka Indiana (US)**
Inventor: **Capriotti, Bruce W., 1410 Mckinley Highway, South Bend Indiana (US)**

(74) Representative: **Geldard, David Guthrie et al, URQUHART-DYKES AND LORD 11th Floor, Tower House Merrion Way, Leeds, LS2 8PB West Yorkshire (GB)**

(54) Compressible photopolymer printing plate.

(57) A layered sheet construction suitable after processing for use as a relief printing plate is provided. The sheet is made of a photosensitive layer comprising an elastomeric polymer, between 5 and 30 phr of an ethylenically unsaturated compound and between 0.1 and 5 phr of a photoinitiator activatable by actinic radiation; a base layer immediately adjacent to said photosensitive layer capable of supporting a relief image after processing; having the same or a different composition than said photosensitive layer. The sheet is bonded to an open or closed cell foam layer having a thickness between 0.25 mm and 6.35 mm. Said foam has a recovery rate of at least 80%, a compression value between 0.076 mm and 0.76 mm and a density of between 32 and 801 kg/m³ and is bonded to a dimensionally stable supporting layer.

0057593

- 1 -

## COMPRESSIBLE PHOTOPOLYMER PRINTING PLATE

The present invention relates to a sheet containing a photopolymer, monomer and initiator suitable for use as a relief printing plate, which sheet is bonded to a compressible foam material which is in turn bonded to a dimensionally stable backing material.

U. S. Patents 2,760,863; 3,024,180; 3,261,686 and 3,764,324 describe soft and hard, flexible and rigid photopolymer compositions in sheet form that are imaged and processed to finished relief printing plates. None of the processes disclosed therein involves the incorporation of a compressible foam layer into the sheet to produce a compressible relief printing plate.

U.S. Patent 4,042,743 discloses a process to produce a compressible offset printing blanket by the incorporation of resin microballoons into the blanket thereby forming a compressible layer.

One technique which is known to produce a compressible layer in offset blankets is to incorporate air into the blanket cement followed by vulcanization to the blanket face. Another technique is to impregnate a highly porous felted fibrous web with an elastomeric material in solution followed by vulcanization.

None of these methods describes the incorporation of a compressible layer onto the sheet material used to form the photopolymer printing plate such that the sheet can be exposed and processed to a finished printing plate that exhibits compressibilty during printing and permits wide impression latitude. Such a wide impression latitude permits the printing of uneven substrates, and the use of presses with lower accuracy in the press cylinders without adversely affecting print quality. The incorporation of an integral compressible layer into the sheet avoids the problems of mounting of flexographic plates on compressible foam tapes. This mounting technique has the problem of the tape stretching during mounting, the tearing of the tape when the plates are positioned and repositioned during plate registration. The aforesaid foam tape mounting technique also has the problem of the tape tearing when plates are demounted and remounted for repeated use. The use of an integral foam backed photopolymer plate in accordance with the present invention permits the use of a much wider range of properties of the compressible layer compared to foam mounting tapes because the integral foam is not subject to the stretching and tearing that foam mounting tapes must resist.

Compressible printing plates of the type manufactured and used pursuant to the present invention are particularly useful in:

    A.    printing on wide webs (films of cellophane, polyethylene, polypropylene, polyester, vinyl and paper where web thickness is in the range of about (1/2 to 5 mils). [0.0127 to 0.127 mm] In wide web printing roll, sag and distortion and machine gauge variation are overcome by the compressibility of foam.

    B.    printing on corrugated cardboard where compressibility in foam allows the plate to apply constant pressure to uneven surfaces giving an even ink laydown for uniform print.

    C.    printing safety papers (checks, bond and stock forms) with even uniform constant tone in background print.

    D.    process printing (4 color printing) where uniformity of ink laydown is critical to proper color development.

A compressible plate also has longer life. The mechanical shock to the plate, in each print motion, causes a gradual wearing of the relief, gradually leading to loss of sharpness in print. Compressible foam absorbs the mechanical shock leaving the relief printing surface relatively unaffected (minimal flattening or distortion) resulting in longer plate life.

The use of an integral foam backed photopolymer plate also permits the use of photographic pin registration systems which permit pre-registration of multiple plate images (as used in multicolor printing). This allows rapid and in most cases instant registration of multiple plates when mounted on presses as with most photopolymer plates. A feature of this invention is that these pin registration systems may now be used with a plate that has the advantages of a compressible backing. This is impossible with foam mounting tapes.

As in the typical flexographic photopolymer printing plate, the plate of the present invention combines three elements:

1.  A relief or image layer which is sensitive to ultraviolet light.

2.  A backing layer which may or may not be sensitive to ultraviolet light that is used to build the relief layer to the proper printing height.

3.  A dimensionally stable backing layer that supports the layers described above and prevents dimensional changes in the plate images which would adversely affect the printing ability of the plate.

These layers are laminated to form a sheet. To convert the sheet into a flexographic printing plate, the image layer is covered by a black and transparent film of the desired printing copy, and exposed to actinic (usually ultraviolet) radiation through the transparency. The light which passes through the transparent portions causes polymerization or crosslinking of the photopolymer that causes insolubilization of the exposed areas. After irradiation, the sheet is washed with a solvent (usually a halogenated hydrocarbon) which removes the unexposed soluble areas of the plate. After oven drying, the sheet is now a rubber printing plate.

The present invention involves the addition of a fourth element to the photopolymer printing plate between the second and third layers described above. This layer consists of an open or closed cell foam with a density of from 32 to 801 kg/m$^3$ (2 to 50 lbs/ft$^3$), desirably of from 288 to 480 kg/m$^3$ (18 to 30 lbs/ft$^3$), in a thickness of 0.250 to 6.35 mm (0.010" to 0.250") depending on the thickness of the plate needed.

This element is applied to the image layer via lamination of the foam to said layer as described hereinafter.

In order for the plates of the present invention to be used effectively in the applications listed above, a suitable amount of foam should be present in the plate. For example, if the total plate thickness is less than 2.54 mm (0.100"), the preferable foam thickness in said plate should be about 0.511 mm (0.02"). If the total plate thickness is between 2.54 mm and 4.32 mm (0.100" and 0.170"), the preferable foam thickness should be about 1.021 mm (0.04"). If the total plate thickness is greater than 4.72 mm (0.170") up to about 2.35 mm (0.250"), the preferable foam thickness should be about 2.03 mm (0.080").

The foam used should possess a good recovery rate, compression value and appropriate density for the end use.

The recovery rate of the foam is measured by determining the percent of the original foam thickness that the foam returns to in a given unit of time after compression. In the instant case, 17578 kg/m$^2$ (25 p.s.i.) is applied for ten seconds via a 12.7 mm (one-half inch) diameter plate on the sample. The plate is removed and the foam sample is allowed to recover for ten seconds. The foam is then measured and the percentage of recovery calculated. The foam used in accordance with the present invention (for all thicknesses) should possess the property that the percent of the original thickness recovered at the end of ten seconds after 17578 kg/m$^2$ (25 p.s.i.) for ten second should be 80% or greater, preferably greater than 92%

The compression value of the foam is obtained using the recovery rate method described above.

The value is obtained by measuring the extent that the foam remains compressed after ten seconds of the aforesaid pressure.

The compression and density values are set forth in Table 1 below:

### TABLE 1

| | | < 2.54 | 2.54-4.32 | 4.32-6.35 |
|---|---|---|---|---|
| Total Plate Thickness | (mm) | < 2.54 | 2.54-4.32 | 4.32-6.35 |
| | (inch) | < 0.100 | 0.100-0.170 | 0.170-0.250 |
| Foam Thickness | (mm) | 0.508 | 1.016 | 2.032 |
| | (inch) | 0.020 | 0.040 | 0.080 |
| Foam Compression Preferred | (mm) | 0.076 | 0.254 | 0.508 |
| | (inch) | 0.003 | 0.010 | 0.020 |
| Maximum | (mm) | 0.127 | 0.508 | 0.762 |
| | (inch) | 0.005 | 0.020 | 0.030 |
| Density | $(kg/m^3)$ | 480 | 320 | 320 |
| | $(lbs./ft^3)$ | 30 | 20 | 20 |

Preferred foams are all closed cell with no skin such as: vinyl, polyurethane, EPDM and polyolefin. The foams must be compatible with solvents used, e.g. not dissolved, weakened swelled, etc.

The foam layer is preferably provided with adhesive on both sides of the foam. This adhesive is desirably in a smooth glassy finish to provide a solvent impermeable bond to a smooth glassy polyester or metal backing and to a smooth glassy photopolymer. Use of a matte finish on the photopolymer, foam adhesive or metal backing which results in less than intimate contact between the surfaces may result in

solvent attack during plate washout with resultant delamination of the photopolymer, foam and backing. This would then necessitate the use of solvent resistant adhesives which are difficult to apply. The foam layer is first applied to a dimensionally stable supporting layer.

In the preferred method of manufacture the photopolymer with or without the carrier backing is pre-back-exposed to ultraviolet light with the normal amount of back exposure used for the plate thickness being used so that the resulting base formed can support a relief image after processing. If the carrier backing is used, it is now stripped from the plate.

The pre-exposed photopolymer without the carrier backing is then laminated to the foam with dimensionally stable backing to produce an integral compressible photopolymer plate material that can be processed normally to a finished compressible photopolymer plate.

The relief or image layer mentioned above is a blend of a photopolymer, between 5 and 30 phr of an ethylenically unsaturated monomer and between 0.1 and 5 phr of a photoinitiator sensitive to actinic radiation. Preferred compositions and methods of preparing same as used in this layer are disclosed in United Kingdom Patents 1,358,062 and 1,395,822, and U.S. Patent Application Serial Number 96,608 filed November 21, 1968, the contents of which are hereby incorporated by reference herein.

Preferred ethylenically unsaturated monomers used herein are: trimethylolpropane triacrylate, pentaerythritol tetraacrylate, 1,6-hexanediol diacrylate, triacrylate of (tris 2-hydroxyethyl) isocyanurate, dipentaerythritol monohydroxypentaacrylate, trimethylolpropane ethoxylate triacrylate and 1,6-hexanediol dimethacrylate.

Preferred photoinitiators are: benzophenone, 2,2-dimethoxy-2-phenylacetophenone, isobutyl benzoin ether, benzoin methyl ether and 2,2-diethoxyacetophenones.

In this invention any photopolymer can be used as long as it can be produced with no backing. The unbacked material is preferred with a smooth glassy surface for easy bonding to the foam; however, other methods of bonding are possible. It is also preferred that the photopolymer be capable of holding its back exposure or not require a back exposure to facilitate maximum detail reproduction of the photopolymer plate material. Also the preferred photopolymer should be extensible enough to allow the construction to be flexible enough to be wrapped around small diameter (12.54 to 15.24 cm / 1 to 6 inch) plate cylinders without buckling. Preferred also is a dimensionally stable polymer which will not shrink on face exposure facilitating its use in close plate-to-plate registration printing as required in four color process printing.

In this invention the preferred method of bonding is by the use of highly tacky adhesives or adhesive tapes; however, other bonding is not excluded, such as urethane, epoxy, cyanoacrylate, anaerobic or hot melt bonding. These methods should, of course, preferably produce a flexible construction.

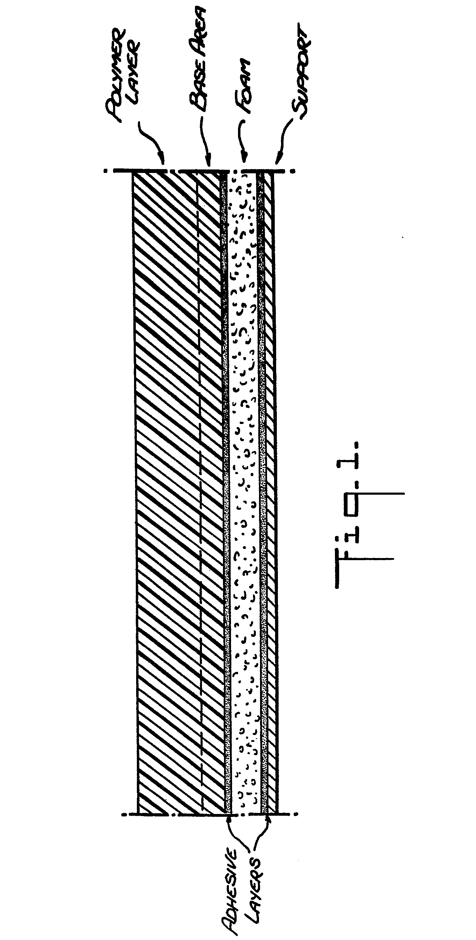

Figure 1 depicts a side view of the various layers of the sheet construction after assembly. The base area depicted may have the same composition as and be homogeneous with the polymer layer or it may be a separate layer with a different composition. The base layer is present to support the printing relief images present after exposure of the plate and washing with solvent.

The following examples are presented by way of illustration and are not to be construed as limiting the scope of the invention.

EXAMPLE 1

A plate was formed using the following materials:

Photopolymer sheet 2.032 mm (0.080") (butadiene-acrylonitrile rubber (NBR),

acrylate monomer and benzophenone at 100:20:2 ratio)

Two sided close cell vinyl foam tape 1.092 mm (0.043")

0.127 mm (0.005") Polyester Film

The photopolymer sheet 1.905 mm (.075"), which is contained between two protective polyester sheets 0.127 mm (.005"), is pre-back-exposed for one minute with ultraviolet radiation. The protective backing polyester sheet is removed leaving intact the protective cover sheet which contains a transferable 0.005 mm (.0002") thick release film. The 1.092 mm (.043") tape supported with a silicone coated polyester film is laminated via a two-roll laminator (set at a 1.168 mm (.046") gap) to the 0.127 mm (.005") polyester film. The gap of the two roll laminators is reset to 3.048 mm (.120"). The release polyester film is removed from the vinyl foam bonded to the 0.127 mm (.005") polyester backing. This is then passed through the laminator nip with the unbacked pre-exposed photopolymer. The finished laminate is heated to 65.5°C (150°F) for 20 minutes to stress relieve the photopolymer. It is then cooled. This produces a sheet of integrally compressible photopolymer material 3.175 mm (.125") thick ready for customer imaging.

The unexpected and unique feature of this plate is its ability to tolerate wide impression changes ($\pm$0.508 mm or .020"), when printing, without complete destruction of the plate or the print quality. This eliminates press bounce and haloing normally associated with high impression, 0.127 to 0.381 mm (.005" to .015") in flexo printing. It also permits the use of presses with inaccurate press cylinders and bearings and allows substrates with poor gauge tolerance ($\pm$0.127 mm or 0.005") to be readily printed with good quality.

The NBR most suitable for use pursuant to the present invention contains 2 to 50% by weight copolymerized acrylonitrile.

EXAMPLE II

Using the procedure outlined in Example I an unbacked photopolymer sheet 1.655 mm (.065"), styrene-butadiene-styrene block copolymer comprising acrylate, monomer and benzophenone at a 100:10:2 ratio, is spray coated with a hot melt adhesive dissolved in a suitable solvent. The hot melt adhesive is a low temperature activated type (65.5-36.7°C or 150-170°F). A polyester backing film of 0.123 mm (.005") thickness is also spray coated with this adhesive.

A closed cell PVC foam sheet of 1.016 mm (.040") thickness and the adhesive coated polyester sheet are then heated to 71.1°C (160°F) in a forced air oven for two minutes. They are then removed and quickly bonded together via a two roll laminator as described in Example I. The foam and backing are again heated along with the unbacked adhesive coated photopolymer in the forced air oven at 65.5°C (150°) for 2 minutes. They are removed and bonded together via the two roll laminator.

This compressible photopolymer sheet is imaged by exposure to ultraviolet light through a photographic negative and washout in perchloroethylene.

EXAMPLE III

Using the procedure described in Example II, a solvent based two component urethane adhesive was substituted for the hot melt adhesive. The adhesive was allowed to dry until tacky and then bonded without the need for heat.

EXAMPLE IV

Using the procedures outlined in Example I, an unbacked photopolymer sheet comprising styrene-isoprene-styrene block copolymer, methacrylate monomer and benzophenone at a 100:10:2 ratio was used. A two sided foam tape 2.034 mm (0.08") thick was bonded to a polyester backing 0.123 mm (.005") thick. This was in turn bonded to the unbacked 4.45 mm (0.175") thick photopolymer sheet described above. This produces a 6.607 mm (.260") thick integrally compressible photopolymer sheet that is imaged to a finished compressible photopolymer plate as described in Example II.

CLAIMS:

1. A layered sheet construction suitable after processing for use as a relief printing plate containing:

    (A)  a photosensitive layer comprising an elastomeric polymer, between 5 and 30 phr of an ethylenically unsaturated compound and between 0.1 and 5 phr of a photoinitiator activatable by actinic radiation;

    (B)  a base layer immediately adjacent to said photosensitive layer capable of supporting a relief image after processing; having the same or a different composition than said photosensitive layer; bonded to

    (C)  an open or closed cell foam layer having a thickness between 0.25 and 6.35 mm (0.010 inch to 0.250 inch), said foam having a recovery rate (measured as hereinbefore described) of at least 80%, a compression value (measured as hereinbefore described) between 0.250 and 6.35 mm (0.003 inch and 0.030 inch) and a density of from 32 to 801 $kg/m^3$ (2 to 50 lbs/ $ft^3$); bonded to

    (D)  a dimensionally stable supporting layer.

2. A sheet construction according to claim 1 wherein the elastomeric polymer is selected from butadiene acrylonitrile rubber, styrene-isoprene-styrene block copolymer, styrene-butadiene-styrene block copolymer and chlorosulfonated polyethylene.

3. A sheet construction according to claim 1 or claim 2 wherein the ethylenically unsaturated compound is selected from

    (A)  trimethylolpropane triacrylate,

    (B)  pentaerythritol tetraacrylate,

    (C)  1,6-hexanediol diacrylate,

    (D)  triacrylate of (tris 2-hydroxyethyl) isocyanurate,

(E)  dipentaerythritol monohydroxypentaacrylate,

(F)  trimethylolpropane ethoxylate triacrylate,

(G)  1,6-hexanediol dimethacrylate.

4.  A sheet construction according to any one of claims 1 to 3 wherein the photoinitiator activatable by actinic radiation is selected from

(A)  benzophenone

(B)  2,2-dimethoxy-2-phenylacetophenone

(C)  isobutyl benzoin ether

(D)  benzoin methyl ether and

(E)  2,2-diethoxyacetophenone.

5.  A sheet construction according to any one of claims 1 to 4 wherein the foam has a recovery rate of about 92% and a density of from 288 to 480 kg/m$^3$ (18 to 30 lbs/ft$^3$).

6.  A sheet construction according to any of claims 1 to 5 wherein the foam is a vinyl, a polyurethane, a polyolefin or an ethylene-propylene terpolymer foam.

7.  A sheet construction according to any one of claims 1 to 6 wherein the photosensitive layer comprises a butadiene-acrylonitrile rubber, trimethylol propane triacrylate and benzophenone, at a ratio of 100:20:2, and the foam is a vinyl foam with a density of from 388 to 480 kg/m$^3$ (18 to 30 lbs/ft$^3$), with a backing of polyester film or a thin steel sheet.

8.  A sheet construction according to any one of claims 1 to 6 wherein the photosensitive layer comprises a styrene-isoprene-styrene block copolymer, 1,6-hexanediol diacrylate and 2,2-dimethoxy-2-phenylacetophenone at a ratio of 100:10:2, and the foam is a vinyl foam with a density of from 388 to 480 kg/m$^3$ (18 to 30 lbs/ft$^3$) with a backing of a polyester film or a thin steel sheet.

POLYMER LAYER

BASE AREA

FOAM

SUPPORT

ADHESIVE LAYERS

Fig.1.